# EUROPÄISCHE PATENTSCHRIFT

(11) **EP 4 045 968 B1**
(45) Veröffentlichungstag und Bekanntmachung des Hinweises auf die Patenterteilung: **03.07.2024**
(21) Anmeldenummer: 20781503.6
(22) Anmeldetag: 28.09.2020
(51) Int. Cl.: G02F 1/1333

(54) **RAHMEN FÜR EIN ELEKTROOPTISCHES DISPLAY UND ELEKTROOPTISCHES DISPLAY MIT RAHMEN**
FRAME FOR ELECTRO-OPTIC DISPLAY AND ELECTRO-OPTIC DISPLAY WITH FRAME
CADRE POUR AFFICHEUR ÉLECTRO-OPTIQUE ET AFFICHEUR ÉLECTRO-OPTIQUE AVEC CADRE

(30) Priorität: 15.10.2019 DE 102019215868
(43) Veröffentlichungstag der Anmeldung: 24.08.2022
(73) Patentinhaber: Continental Automotive Technologies GmbH, 30175 Hannover (DE)
(72) Erfinder: ALBAYRAK, Gökay, 60488 Frankfurt am Main (DE); HAAS, Florian, 60488 Frankfurt am Main (DE)
(74) Vertreter: Continental Corporation
(86) Internationale Anmeldenummer: PCT/EP2020/077104
(87) Internationale Veröffentlichungsnummer: WO 2021/073856

(56) Entgegenhaltungen:
- DE-T5-112012 007 216
- US-A1- 2019 179 193

## Beschreibung

Die Erfindung betrifft einen Rahmen zur seitlichen Halterung eines elektrooptischen Displays und ein elektrooptisches Display mit diesem Rahmen. Aus dem Stand der Technik sind derartige Rahmen für elektrooptische Displays bekannt, die in einer Längenausdehnung parallel zur Oberfläche des elektrooptischen Displays starre Elemente aufweisen. Hierbei wird unter Oberfläche die größte Ausdehnung der Oberfläche des Displays verstanden, in der auch die von einem Beobachter des Displays wahrnehmbare Information dargestellt wird. Hiervon klar zu unterscheiden sind die Seitenflächen des elektrooptischen Displays.

Aus der US 2019179193 A1 ist eine hintere Abdeckung, die mit der hinteren Oberfläche eines Anzeigepanels gekoppelt ist, und eine Anzeigevorrichtung mit einer solchen hinteren Abdeckung bekannt. Die hintere Abdeckung des elektrooptischen Displays weist dort in einer Längenausdehnung der Abdeckung starre Elemente auf, wobei sich die Längenausdehnung parallel zur Oberfläche des elektrooptischen Displays befindet, wobei zwischen den in der Längenausdehnung starren Elementen (primäre und sekundäre Einheitsplatten) in der Längenausdehnung elastische Elemente (Verbindungseinheiten) angeordnet sind. Die Rückabdeckung des Displays der US2019179193 A1 ist ein stabilisierendes Gerüst und somit ein Halte-Rahmen der Anzeige, wie in Absatz [0057] der US2019179193 A1 explizit beschrieben Es ist üblich, dass der Rahmen mit der Oberfläche des elektrooptischen Displays starr verbunden, beispielsweise verklebt ist. Wenn das elektrooptische Display und der Rahmen unterschiedliche Wärmeausdehnungskoeffizienten aufweisen kann es vorkommen, dass bei starken Wärmeänderungen die Klebeverbindung reißt. Aufgabe der vorliegenden Erfindung ist es daher, einen Rahmen anzugeben, bei dem ein Lösen der Verbindungen verhindert werden kann. Diese Aufgabe wird dadurch gelöst, dass zwischen den in Längenausdehnung starren Elementen in Längenausdehnung elastische Elemente angeordnet sind. Hierdurch wird erreicht, dass die Krafteinwirkung auf die Verbindungen geringer ist und so ein Lösen der Verbindung verhindert werden kann. Diese Ausgestaltung hat auch Vorteile für einen Rahmen für ein elektrooptisches Display, wenn der Rahmen mit dem elektrooptischen Display nicht verklebt ist, sondern beispielsweise das Display durch eine spezielle Ausgestaltung des Rahmens in den Rahmen gepresst ist und so auf eine Verklebung verzichtet werden kann. So kann dann beispielsweise bei der Montage des Rahmens mit dem Display der Rahmen kurzzeitig gestreckt werden und anschließend Teile des Rahmens über die Ränder des Displays geschoben werden.

Wenn die elastischen Elemente aus dem gleichen Werkstoff bestehen wie die in Längsrichtung starren Elemente, ist der Rahmen besonders einfach herstellbar.

Wenn die elastischen Elemente eine im Längsschnitt wellenförmige oder mäanderförmige Form aufweisen kann auf einfache Weise ein in Längenausdehnung elastisches Element realisiert werden.

Dies wird besonders einfach realisiert, wenn die in Längsrichtung starren Elemente einstückig mit den in Längsrichtung elastischen Elementen hergestellt sind. Dies wird dann besonders einfach erreicht, wenn der Rahmen einstückig spritzgegossen ist.

Wenn der Rahmen aus Kunststoff besteht, kann er zum einen einfach spritzgegossen werden und zum anderen die Elastizität einer wellenförmigen oder mäanderförmigen Ausgestaltung der elastischen Elemente realisiert werden. Die elastischen Elemente können beispielsweise auch spiralförmig ausgestaltet sein. Dann ist aber ihre Herstellung aufwändiger als bei einer wellenförmigen oder mäanderförmigen Ausgestaltung.

Wenn der Rahmen Auflageflächen für das elektrooptisches Display aufweist, kann der Rahmen einfach mit dem elektrooptischen Display verklebt werden.

Wenn der Rahmen Umgreifungen aufweist, die das elektrooptische Display senkrecht zur Oberfläche des elektrooptischen Displays an den Rändern des elektrooptischen Displays umgreifen, kann das elektrooptische Display von diesen Umgreifungen vollständig gehalten werden und gegebenenfalls auf eine Verklebung zwischen dem Display und dem Rahmen verzichtet werden. Die Umgreifungen umgreifen das Display in äußeren Bereichen der des Displays. So kann das elektrooptische Display in dem Rahmen gehalten werden und muss nicht unbedingt mit dem Rahmen zusätzlich verklebt sein. Im Querschnitt kann die Umgreifung beispielsweise U-förmig oder V-förmig ausgestaltet sein. Bei einer V-förmigen Ausgestaltung der Umgreifung liegt das Display mit seinen Kanten auf den Schenkeln der im Querschnitt V-förmigen Umgreifung auf.

Ein elektrooptisches Display mit einem Rahmen kann mit einem Rahmen gemäß der vorhergehenden Beschreibung realisiert sein. Hierbei kann das elektrooptische Display mit dem Rahmen verklebt sein. Wenn der Rahmen Umgreifungen aufweist, die das Display senkrecht zur Oberfläche des Displays umfassen, kann auf eine Verklebung des Rahmens mit dem Display gegebenenfalls verzichtet werden, da das elektrooptische Display auch so schon vollständig in dem Rahmen gehalten ist.

Die Erfindung wird nachfolgend anhand der Figuren näher erläutert.

Es zeigen:
- Figur 1: die Aufsicht auf einen Rahmen eines besonders bevorzugten Ausführungsbeispiels der Erfindung
- Figur 2: die Aufsicht auf einen Rahmen eines weiteren besonders bevorzugten Ausführungsbeispiels der Erfindung mit einem elektrooptischen Display
- Figur 3: den Schnitt BB aus Figur 2
- Figur 4: eine erste mögliche mäanderförmige Ausgestaltung eines elastischen Elementes
- Figur 5: eine zweite mögliche mäanderförmige Ausgestaltung eines elastischen Elementes

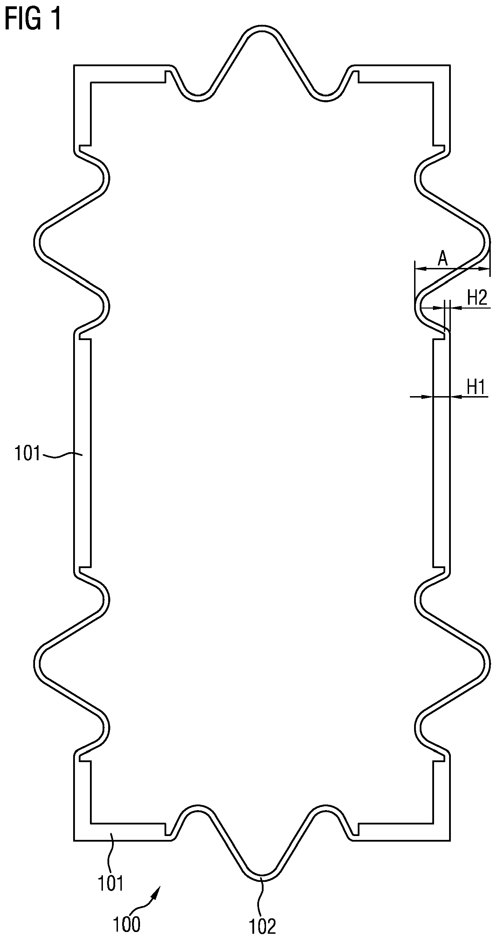

In Figur 1 erkennt man einen Rahmen 100 mit starren Elementen 101 und elastischen Elementen 102. Der Rahmen 100 ist einstückig aus Kunststoff gegossen. Die elastischen Elemente 102 sind wellenförmig ausgestaltet. Hierdurch ist es möglich, dass der Rahmen 100 parallel zu den starren Elementen 101 gestaucht oder verlängert werden kann, ohne dass eine Kraft auf ein im Rahmen befindliches nicht dargestelltes elektrooptisches Display übermäßig groß werden kann und eine mögliche Verklebung zwischen dem Rahmen und dem elektrooptischen Display abreißen kann. Die elastischen Elemente 102 können beispielsweise auch mäanderförmig ausgestaltet sein. Im Ausführungsbeispiel in Figur 1 weisen die starren Elemente eine Breite H1 auf, während die elastischen Elemente eine gegenüber der Breite H1 kleinere Breite H2 aufweisen. Hierdurch wird die Elastizität der elastischen Elemente 102 erhöht. Eine Amplitude A der wellenförmigen Ausgestaltung der elastischen Elemente 102 ist im Beispielsfall größer als die Breite H1 dargestellt. Diese Darstellung dient der besseren Wahrnehmbarkeit der Funktionsweise der elastischen Elemente 102. In einer realen Ausgestaltung kann die Amplitude A auch der Breite H1 entsprechen oder auch eine andere Größe aufweisen.

Man erkennt weiterhin, dass die wellenförmige Ausgestaltung des elastischen Elementes 102 eine andere Breite H2 aufweist als die Breite H1 des starren Elements 101.

Hierdurch wird im dargestellten Ausführungsbeispiel die Elastizität des elastischen Elementes 102 weiter erhöht. Es ist aber auch möglich, dass die Breite H2 der elastischen Elemente 102 gegenüber der Breite H1 der starren Elemente 101 gleich oder größer ist.

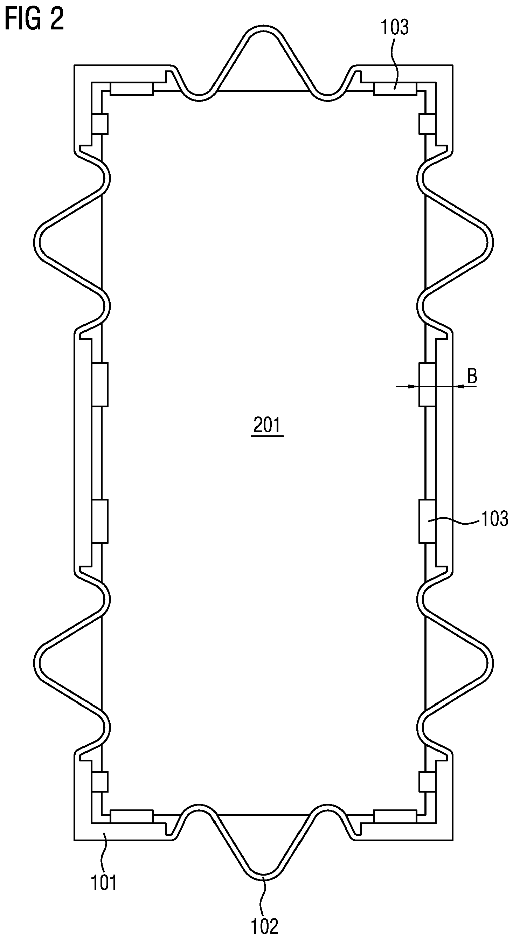

In Figur 2 erkennt man den Rahmen 100 und die Oberfläche 201 des ansonsten nicht dargestellten elektrooptischen Displays 200. Der Rahmen 100 weist gegenüber dem Rahmen 100 aus Figur 1 zusätzlich noch Umgreifungen 103 auf, die das elektrooptische Display 200 an seinen Rändern senkrecht zu seiner Oberfläche 201 teilweise umgreifen. Zur Montage kann der Rahmen 100 so weit gespannt werden, bis das elektrooptische Display 200 zwischen die Umgreifungen 103 platziert werden kann und beim Entspannen des Rahmens 100 die Umgreifungen 103 das elektrooptische Display 200 an seinen Seiten umgreifen, wie in Figur 2 dargestellt.

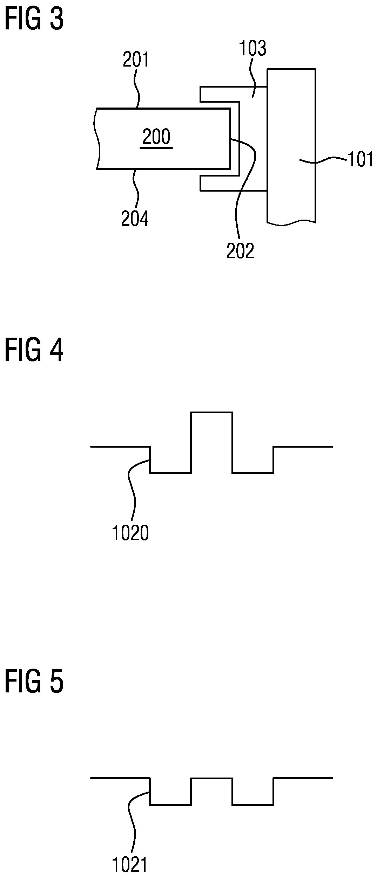

Eine mögliche Ausgestaltung dieser Umgreifung zeigt Figur 3. Man erkennt in Figur 3, dass das Display 201 weiterhin eine Seitenfläche 202 und eine Unterfläche 204 aufweist. Die Umgreifung 103 umgreift das Display 200 in einem äußeren Bereich der Oberfläche 201 und der Unterfläche 204 und im Bereich der Seitenfläche 202. So wird das elektrooptische Display 200 in dem Rahmen 100 gehalten und muss nicht unbedingt mit dem Rahmen 100 zusätzlich verklebt sein. Dabei kann das Display 200 in die Umgreifung gepresst sein oder wie in Figur 3 dargestellt ein gewisses Spiel aufweisen. Bei einer nicht dargestellten V-förmigen Ausgestaltung der Umgreifung liegt das Display 200 mit seinen Kanten auf den Schenkeln der im Querschnitt V-förmigen Umgreifung auf, wobei es sich um die Kanten zwischen der Oberfläche 201 und Seitenfläche 202 und die Kanten zwischen der Seitenfläche 202 und Unterfläche 204 handelt.

Figur 4 zeigt eine erste mäanderförmige Ausgestaltung 1020 des elastischen Elementes 102.

Figur 5 zeigt eine zweite mäanderförmige Ausgestaltung 1021 des elastischen Elementes 102.

## Patentansprüche

1. Rahmen (100) zur seitlichen Halterung eines elektrooptischen Displays (200) aufweisend in einer Längenausdehnungsrichtung des Rahmens (100) starre Elemente (101), wobei sich die Längenausdehnung des Rahmens (100) parallel zur Oberfläche (201) des elektrooptischen Displays (200) erstreckt, wobei zwischen den in Längsrichtung starren Elementen (101) in Längsrichtung elastische Elemente (102) angeordnet sind, und der Rahmen (100) dergestalt ist, das zu haltende elektrooptische Display (200) zu umranden.

2. Rahmen (100) nach Patentanspruch 1, wobei die in Längsrichtung elastischen Elemente (102) aus dem gleichen Werkstoff bestehen wie die in Längsrichtung starren Elemente (101).

3. Rahmen (100) nach einem der vorstehenden Patentansprüche, wobei die in Längsrichtung elastischen Elemente (102) eine im Längsschnitt wellenförmige oder mäanderförmige Form (102, 1020, 1021) aufweisen.

4. Rahmen (100) nach einem der vorstehenden Patentansprüche, wobei die in Längsrichtung starren Elemente (101) einstückig mit den in Längsrichtung elastischen Elementen (102) hergestellt sind.

5. Rahmen (100) nach einem der vorstehenden Patentansprüche, wobei der Rahmen (100) aus Kunststoff besteht.

6. Rahmen (100) nach Patentanspruch 5, wobei der Rahmen (100) spritzgegossen ist.

7. Rahmen (100) nach einem der vorstehenden Patentansprüche, wobei der Rahmen (100) Auflageflächen für das elektrooptische Display aufweist.

8. Rahmen (100) nach einem der vorstehenden Patentansprüche, wobei der Rahmen (100) Umgreifungen (103) aufweist, die geeignet sind, das zu haltende elektrooptische Display (200) senkrecht zur Oberfläche (201) des elektrooptischen Displays im Bereich der Ränder des elektrooptischen Displays (200) zu umgreifen.

9. Elektrooptisches Display (200) mit einem Rahmen (100) nach einem oder mehreren der vorstehenden Patentansprüche zur seitlichen Halterung des elektrooptischen Displays (200).

10. Elektrooptisches Display (200) nach Patentanspruch 9 mit einem Rahmen (100) nach Patentanspruch 7 oder 8, wobei das elektrooptische Display (200) mit den Auflageflächen des Rahmens (100) verbunden ist

11. Elektrooptisches Display (200) nach Patentanspruch 9 mit einem Rahmen (100) nach Patentanspruch 7 oder 8, wobei das elektrooptische Display (200) mit den Auflageflächen des Rahmens (100) verklebt ist.

## Claims

1. Frame (100) for laterally holding an electro-optic display (200), comprising elements (101) which are rigid in a direction of longitudinal extent of the frame (100), wherein the longitudinal extent of the frame (100) runs parallel to the surface (201) of the electro-optic display (200), wherein elements (102) which are elastic in the longitudinal direction are arranged between the elements (101) which are rigid in the longitudinal direction, and the frame (100) is designed to border the electro-optic display (200) to be held.

2. Frame (100) according to Patent Claim 1, wherein the elements (102) which are elastic in the longitudinal direction are composed of the same material as the elements (101) which are rigid in the longitudinal direction.

3. Frame (100) according to either of the preceding patent claims, wherein the elements (102) which are elastic in the longitudinal direction have a shape (102, 1020, 1021) which is wavy or meandering in longitudinal section.

4. Frame (100) according to any of the preceding patent claims, wherein the elements (101) which are rigid in the longitudinal direction are produced in one piece with the elements (102) which are elastic in the longitudinal direction.

5. Frame (100) according to any of the preceding patent claims, wherein the frame (100) is composed of plastic.

6. Frame (100) according to Patent Claim 5, wherein the frame (100) is injection-moulded.

7. Frame (100) according to any of the preceding patent claims, wherein the frame (100) has bearing surfaces for the electro-optic display.

8. Frame (100) according to any of the preceding patent claims, wherein the frame (100) has clasps (103), which are suitable for engaging around the electro-optic display (200) to be held perpendicularly to the surface (201) of the electro-optic display in the region of the peripheries of the electro-optic display (200).

9. Electro-optic display (200) having a frame (100) according to one or more of the preceding patent claims for laterally holding the electro-optic display (200).

10. Electro-optic display (200) according to Patent Claim 9 having a frame (100) according to Patent Claim 7 or 8, wherein the electro-optic display (200) is connected to the bearing surfaces of the frame (100).

11. Electro-optic display (200) according to Patent Claim 9 having a frame (100) according to Patent Claim 7 or 8, wherein the electro-optic display (200) is adhesively bonded to the bearing surfaces of the frame (100).

## Revendications

1. Cadre (100) pour le maintien latéral d'un afficheur électro-optique (200), présentant des éléments (101) rigides dans une direction d'extension longitudinale du cadre (100), l'extension longitudinale du cadre (100) s'étendant parallèlement à la surface (201) de l'afficheur électro-optique (200), des éléments (102) élastiques dans la direction longitudinale étant agencés entre les éléments (101) rigides dans la direction longitudinale, et le cadre (100) étant conçu de manière à entourer l'afficheur électro-optique (200) à maintenir.

2. Cadre (100) selon la revendication 1, dans lequel les éléments (102) élastiques dans la direction longitudinale sont constitués du même matériau que les éléments (101) rigides dans la direction longitudinale.

3. Cadre (100) selon l'une des revendications précédentes, dans lequel les éléments (102) élastiques dans la direction longitudinale présentent une forme (102, 1020, 1021) ondulée ou en méandres en coupe longitudinale.

4. Cadre (100) selon l'une des revendications précédentes, dans lequel les éléments (101) rigides dans la direction longitudinale sont fabriqués d'une seule pièce avec les éléments (102) élastiques dans la direction longitudinale.

5. Cadre (100) selon l'une des revendications précédentes, le cadre (100) étant constitué de matière plastique.

6. Cadre (100) selon la revendication 5, dans lequel le cadre (100) est moulé par injection.

7. Cadre (100) selon l'une des revendications précédentes, le cadre (100) présentant des surfaces d'appui pour l'afficheur électro-optique.

8. Cadre (100) selon l'une des revendications précédentes, le cadre (100) présentant des pièces d'enveloppement (103) qui sont adaptées pour envelopper l'afficheur électro-optique (200) à maintenir, perpendiculairement à la surface (201) de l'afficheur électro-optique, dans la zone des bords de l'afficheur électro-optique (200).

9. Afficheur électro-optique (200) avec un cadre (100) selon une ou plusieurs des revendications précédentes pour le maintien latéral de l'afficheur électro-optique (200).

10. Afficheur électro-optique (200) selon la revendication 9 avec un cadre (100) selon la revendication 7 ou la revendication 8, l'afficheur électro-optique (200) étant relié aux surfaces d'appui du cadre (100).

11. Afficheur électro-optique (200) selon la revendication 9 avec un cadre (100) selon la revendication 7 ou la revendication 8, l'afficheur électro-optique (200) étant collé aux surfaces d'appui du cadre (100).
